# EUROPEAN PATENT SPECIFICATION

(11) **EP 3 467 863 B1**
(45) Date of publication and mention of the grant of the patent: **06.04.2022**
(21) Application number: 17749205.5
(22) Date of filing: 30.05.2017
(51) Int. Cl.: H01H 23/14, H01H 3/02

(54) **CONTROL DEVICE**
STEUERVORRICHTUNG
DISPOSITIF DE COMMANDE

(30) Priority: 02.06.2016 ES 201630735
(43) Date of publication of application: 10.04.2019
(73) Proprietor: Simon, S.A.U., 08013 Barcelona (ES)
(72) Inventor: RIQUÈ REBULL, Adrià, 08013 Barcelona (ES); BATISTE MAYAS, Clara, 08013 Barcelona (ES); PLAJA MIRÓ, Salvi, 08013 Barcelona (ES); GRAGERA GIL, Miguel, 08013 Barcelona (ES); DÍAZ GONZÁLEZ, Susana, 08013 Barcelona (ES)
(74) Representative: Balder IP Law, S.L.
(86) International application number: PCT/ES2017/070371
(87) International publication number: WO 2017/207850

(56) References cited:
- WO-A2-2007/150058
- DE-A1-102010 024 776
- US-A1- 2012 318 657
- US-A1- 2014 265 640

## Description

### OBJECT OF THE INVENTION

The object of the present invention is a controlling device for the turning on, turning off and adjustment of the light intensity of a lighting system comprising at least one light fitting.

### BACKGROUND OF THE INVENTION

Currently, controlling devices are known that use an adjusting button connected to a potentiometer for controlling the light intensity level of a light fitting. Thus, a user can adjust the level of lighting by rotating said button. This button can be pressed by a user to turn on or turn off said light fitting. Additionally, this controlling device can have a control unit that can comprise memorized light levels.

Even though these devices function correctly, they penalize the control of the light intensity level compared to the turning on and turning off function, such that the user intuitively uses the device as a simple switching without using the light intensity control function.

Furthermore, these devices from the state of the art do not adjust and indicate the level of lighting at which the light fitting is set when it is turned off as well as turned on.
US 2012/318657 A1 discloses a control device for controlling lights.

### DESCRIPTION OF THE INVENTION

The present invention relates to a controlling device according to claim 1.

Additionally, the controlling device comprises an electrical connection, heat dissipation elements and a casing that protects it and provides connection means for its integration in a box able to be flush-mounted, preferably, in a wall or in a surface box.

The switching mechanism and the adjusting mechanism are actuated by means of the actuation of the user on the same means, namely the interface of the controlling device.

More specifically, the switching mechanism comprises a switch with two states that allows for, according to the open or closed state thereof, the electrical powering of the lighting.

The interface comprises at least a sensor, and preferably comprises two sensors that are preferably capacitive sensors that are housed in the inner surface of the interface, such that the capacitive sensors occupy the majority of the inner surface of the interface. These two capacitive sensors are able to produce an essentially linear analog adjusting signal. This analog adjusting signal changes based on a linear movement parallel to the controlling device, performed by the user throughout the outer upper surface of the interface. The analog adjusting signal in each point of the length of the surface of the interface is related to a light intensity such that the actuation of the user on a point of the length of the surface of the interface makes it so that the capacitive sensors transmit to the control unit of the adjusting mechanism a signal that is determined and related to a specific light intensity.

It is worth noting that the control unit comprises a first microcontroller that in turn comprises at least an analog/digital converter for converting said analog adjusting signal to a digital one.

Thus, the first microcontroller transmits a digital signal so that the lighting system provides the light intensity according to this signal, in the case in which it is turned on or so that it has a starting light intensity when it is turned on.

It is worth noting that the actuation performed by the user on the interface can be by means of the contact on it or by means of the positioning thereof at a close distance approximately perpendicular to said surface.

Preferably, the interface additionally comprises an indicating mechanism linked to the adjusting mechanism and intended to continuously show the light intensity of the lighting system to the user.

This indicating mechanism comprises a plurality of LEDs also controlled by the control unit of the adjusting mechanism in order to be turned on linearly depending on the signal related to the light intensity provided by the capacitive sensors, the light system being turned on or turned off.

In a preferred embodiment, the indicating mechanism comprises means that cause signals such as sounds, scents, vibrations...

Preferably the indicating mechanism is in the interface.

Preferably, the controlling device further comprises a wireless communication mechanism. More specifically, this wireless communication mechanism is linked to the first microcontroller of the control unit of the adjusting mechanism, and comprises a radio frequency antenna and a radio frequency module, the antenna being adjacent to the previously described capacitive sensor. In this way, the assembly of the capacitive sensor and the antenna occupy the entirety of the inner surface of the interface. Preferably, both are integrated in a PCB or directly printed on the inner surface of the interface, more preferably they are printed on the inner surface of the actuation surface of a rocker key or are integrated in a PCB affixed to the inner surface of the actuation surface of the rocker key.

Preferably, the communications module is preferably housed on the inside of the rocker key.

Preferably, the wireless communication module is connected to the control unit of the adjusting mechanism in order to enable the communication thereof with external mechanisms.

In a preferred embodiment of the invention, the interface is the actuation surface of an interchangeable rocker key that can connect and disconnect from a module integrated in the wall that comprises the switching and the electrical connections.

Thus, the present invention enables using the entirety of the surface of the interface both for adjusting the light intensity and for turning the light fitting on and off, integrating a functional portion like the antenna of the communication module and the sensors in an ornamental portion diminishing the size of the device.

Furthermore, the present invention enables adjusting and indicating the light intensity of the light fitting if it is turned on, and enables adjusting and indicating the starting light intensity while it is turned off.

### DESCRIPTION OF THE DRAWINGS

As a complement to the description provided herein and for the purpose of helping to make the characteristics of the invention more readily understandable, in accordance with a preferred practical embodiment thereof, said description is accompanied by a set of drawings constituting an integral part of the same, which by way of illustration and not limitation represent the following:

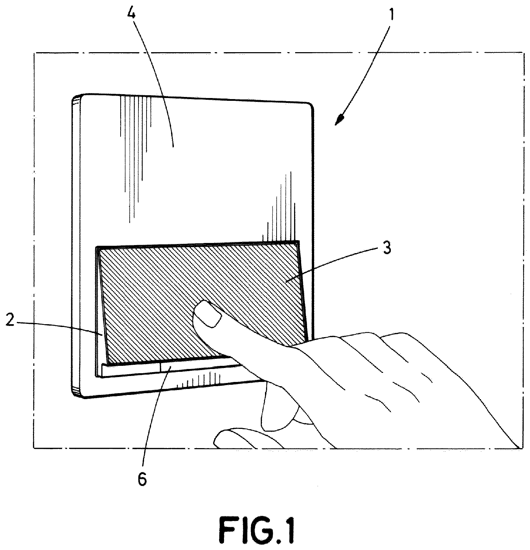

Figure 1.- Shows a schematic view of the connecting device.

### PREFERRED EMBODIMENT OF THE INVENTION

The present invention, as shown in figure 1, relates to a controlling device
(1) for controlling a lighting system, not shown, comprising at least one light fitting, wherein said controlling device (1) is linked with said lighting system and comprises:
   - a switching mechanism, not shown, linked to the lighting system and intended to turn the lighting system on and off.
   - an adjusting mechanism comprising a control unit and is intended to adjust the light intensity of the light fitting, and
   - an interface, by way of actuation surface of a rocker key (2) preferably surrounded by a frame (4), linked to a switching mechanism and to an adjusting mechanism, able to be actuated by a user in order to control the turning on and off, as well as adjusting the intensity of the lighting.

The switching mechanism comprises a switch with two states that enables, according to the open or closed state thereof, the electrical powering of the lighting. More specifically, the switch is housed in an internal block of the controlling device (1), such that the state thereof depends on whether or not the rocker key (2) presses it, and in turn on whether or not the user has pressed said rocker key (2). Additionally, this internal block comprises the electrical connections with the light fitting and a casing that protects it.

The rocker key (2) comprises an outer surface (3) that is the interface of the controlling device (1) intended to receive the contact of the user, for example by means of the hand, a finger of a user or similar, for controlling the turning on and off of the light fitting, as well as for adjusting the intensity of the lighting.

More specifically, on the inside of the rocker key (2) a first printed circuit of polyamide with a thickness of 70um is inserted which approximately occupies the entirety of the surface thereof. This printed circuit comprises an adjusting mechanism made up of two capacitive sensors and a radio frequency antenna, which makes up part of a wireless communication mechanism that further comprises a radio frequency module.

Alternatively, both the capacitive sensors and the radio frequency antenna are printed in the inner surface of the rocker key (2).

Thus, the user, upon sliding the hand, the finger or similar over said outer surface from one end towards the opposite end, usually from the left edge towards the right one, the capacitive sensors create, preferably, an analog adjusting signal, the value of which is increasing or decreasing depending on the movement and which is sent to an adjusting mechanism control unit.

More specifically, the capacitive sensors connect to the control unit comprising a first microcontroller endowed with an analog/digital converter that converts the analog adjusting signal into a digital one and processes it. Thus, the control unit enables, or interferes in, the passage of electrical current for determining the light intensity of the lighting system for all kinds of light fittings (reactive, capacitive or inductive).

Optionally, said radio frequency module of the communication mechanism manages the communications made by means of the radio frequency antenna with external elements by means of the Z-Wave protocol.

Preferably, the first microcontroller is inserted in the first printed circuit. Alternatively, it is inserted in a second printed circuit and linked to the first printed circuit by means of strips. This second printed circuit is housed in the rocker key (2).

Alternatively, this second printed circuit is housed in the internal block of the controlling device (1).

Additionally, this rocker key (2) in the outer surface thereof, in other words in the interface, comprises an indicating mechanism (6). This indicating mechanism (6) indicates to the user, regardless of whether the light fitting is turned on or off, the light intensity level of the light fitting, and is controlled by the first microcontroller comprised in the control unit.

Specifically, the indicating mechanism (6) comprises a series of LEDs arranged in a line, wherein a greater number of turned-on LEDs indicates a greater light intensity level of the light fitting from a minimum value to a maximum value.

More specifically, and in a non-limiting manner, the first microcontroller achieves that, upon sliding a finger over the surface of the interface from the left edge towards the right one, a first LED lights up and increases the intensity thereof until reaching a limit value that would be maintained at the same time as the intensity of the second LED also increases towards the limit value according to the movement of the finger passing along the surface of the rocker key (2), and in this way successively until the finger stops, or the last LED is lit up.

Additionally, the first microcontroller achieves that, when the lighting system is turned off, with the closeness or the contact of the user on the surface, the corresponding LEDs turn on indicating the starting intensity of the lighting system if the light fitting were turned on in that moment. Upon sliding the hand, the finger or similar from this starting intensity point towards one side or the other, the LEDs turn on or turn off, and correspondingly the intensity thereof is increased or decreased until the point in which the finger of the user stops.

Optionally, the wireless communication mechanism comprises a Wi-Fi type communications module.

## Claims

1. A controlling device (1) for controlling a lighting system comprising at least a light fitting, wherein said controlling device (1) is linked to said lighting system, and it is **characterized in that** comprises:
• A switching mechanism linked to the lighting system and intended to turn the lighting system on and off;
• An adjusting mechanism comprising a control unit intended to adjust the light intensity of the lighting system; and
• An interface, linked to the switching mechanism and to the adjusting mechanism, the interface being the actuation surface of a rocker key (2) having a rotation axis, able to be actuated by a user in order to control the turning on and off, by means of applying a pressure to the interface as well as adjusting the intensity; the interface comprising at least a sensor that transmits a signal that is determined and related to a specific light intensity to the control unit.

2. The controlling device (1) according to claim 1, **characterized in that** the interface additionally comprises an indicating mechanism (6) linked to the control unit and intended to continuously show the light intensity to the user regardless of whether or not it is turned on or off.

3. The controlling device (1) according to claim 1, **characterized in that** the switching mechanism comprises a switch with two states that enables, according to the open or closed state thereof, the electrical powering of the lighting system.

4. The controlling device (1) according to claim 1, **characterized in that** the interface comprises at least a capacitive sensor that substantially covers all of the inner surface thereof.

5. The controlling device (1) according to claim 4, **characterized in that** the interface comprises two capacitive sensor that substantially cover all of the inner surface thereof and that are able to produce an essentially linear analog adjusting signal depending on a linear movement made by the user on the outer surface(3) of the interface.

6. The controlling device (1) according to claim 5, **characterized in that** the control unit comprises a first microcontroller that in turn comprises at least one analog/digital converter for converting an analog adjusting signal to a digital one.

7. The controlling device (1) according to claim 1, **characterized in that** it further comprises a wireless communication mechanism connected to the control unit in order to enable the communication with the external mechanisms.

8. The controlling device (1) according to claim 1, wherein the sensor is arranged parallel to the rotation axis of the rocker key (2) such that the light intensity is controlled by means of a linear movement parallel to the rotation axis of the rocker key (2), and the indicating mechanism (6) comprises a plurality of LEDs controlled by said control unit of the adjusting mechanism for being linearly turning on depending on the light intensity of the light fitting, it being turned on or turned off, and the wireless communication mechanism comprises a radio frequency antenna and a radio frequency module.

## Patentansprüche

1. Steuervorrichtung (1) zur Steuerung eines Beleuchtungssystems aufweisend mindestens eine Beleuchtungsanlage, wobei die Steuervorrichtung (1) mit dem Beleuchtungssystem verbunden ist und **dadurch gekennzeichnet ist, dass** sie aufweist:
• einen Schaltmechanismus, der mit dem Beleuchtungssystem verbunden und dazu bestimmt ist, das Beleuchtungssystem ein- und auszuschalten;
• einen Einstellmechanismus mit einer Steuereinheit, der dazu bestimmt ist, die Lichtstärke des Beleuchtungssystems einzustellen; und
• eine Schnittstelle, die mit dem Schaltmechanismus und mit dem Einstellmechanismus verbunden ist, wobei es sich bei der Schnittstelle um die Betätigungsfläche einer Wipptaste (2) mit einer Drehachse handelt, die von einem Benutzer betätigt werden kann, um das Ein- und Ausschalten durch das Aufbringen von Druck auf die Schnittstelle sowie das Einstellen der Lichtstärke zu steuern; wobei die Schnittstelle mindestens einen Sensor aufweist, der ein Signal, das ermittelt wird und mit einer bestimmten Lichtstärke verknüpft ist, zu der Steuereinheit überträgt.

2. Steuervorrichtung (1) nach Anspruch 1, **dadurch gekennzeichnet, dass** die Schnittstelle zusätzlich einen Anzeigemechanismus (6) aufweist, der mit der Steuereinheit verbunden ist und dazu bestimmt ist, dem Benutzer kontinuierlich die Lichtstärke anzuzeigen, unabhängig davon, ob das Licht ein- oder ausgeschaltet ist.

3. Steuervorrichtung (1) nach Anspruch 1, **dadurch gekennzeichnet, dass** der Schaltmechanismus einen Schalter mit zwei Zuständen aufweist, der je nach seinem geöffneten oder geschlossenen Zustand die elektrische Versorgung des Beleuchtungssystems ermöglicht.

4. Steuervorrichtung (1) nach Anspruch 1, **dadurch gekennzeichnet, dass** die Schnittstelle mindestens einen kapazitiven Sensor aufweist, der im Wesentlichen deren gesamte Innenseite bedeckt.

5. Steuervorrichtung (1) nach Anspruch 4, **dadurch gekennzeichnet, dass** die Schnittstelle zwei kapazitive Sensoren aufweist, die im Wesentlichen deren gesamte Innenseite bedecken und die in der Lage sind, in Abhängigkeit von einer durch den Benutzer auf der Außenseite (3) der Schnittstelle vorgenommene lineare Bewegung ein im Wesentlichen lineares analoges Einstellsignal zu erzeugen.

6. Steuervorrichtung (1) nach Anspruch 5, **dadurch gekennzeichnet, dass** die Steuereinheit einen ersten Mikrocontroller aufweist, der wiederum mindestens einen Analog-Digital-Wandlerzum Umwandeln des analogen Einstellsignals in ein digitales aufweist.

7. Steuervorrichtung (1) nach Anspruch 1, **dadurch gekennzeichnet, dass** sie ferner einen Mechanismus zur drahtlosen Kommunikation aufweist, der mit der Steuereinheit verbunden ist, um die Kommunikation mit den externen Mechanismen zu ermöglichen.

8. Steuervorrichtung (1) nach Anspruch 2 und Anspruch 7, wobei der Sensor parallel zu der Drehachse der Wipptaste (2) angeordnet ist, sodass die Lichtstärke mit Hilfe einer linearen Bewegung parallel zu der Drehachse der Wipptaste (2) gesteuert wird, und wobei der Anzeigemechanismus (6) eine Vielzahl von LEDs aufweist, die von der Steuereinheit des Einstellmechanismus zum linearen Einschalten in Abhängigkeit von der Lichtstärke der Beleuchtungsanlage gesteuert werden, der einoder ausgeschaltet wird, und wobei der Mechanismus zur drahtlosen Kommunikation eine Hochfrequenzantenne und ein Hochfrequenzmodul aufweist.

## Revendications

1. Dispositif de commande (1) pour commander un système d'éclairage comprenant au moins un luminaire, lequel dispositif de commande (1) est relié audit système d'éclairage, et il est **caractérisé en ce qu'**il comprend :
- un mécanisme de commutation relié au système d'éclairage et destiné à allumer et éteindre le système d'éclairage ;
- un mécanisme de réglage comprenant une unité de commande destinée à régler l'intensité lumineuse du système d'éclairage ; et
- une interface, reliée au mécanisme de commutation et au mécanisme de réglage, l'interface étant la surface d'actionnement d'un bouton à bascule (2) ayant un axe de rotation, apte à être actionné par un utilisateur en vue de commander l'allumage et l'extinction, en appliquant une pression sur l'interface ainsi qu'en réglant l'intensité ; l'interface comprenant au moins un capteur qui transmet à l'unité de commande un signal qui est déterminé et lié à une intensité lumineuse spécifique.

2. Dispositif de commande (1) selon la revendication 1, **caractérisé en ce que** l'interface comprend en outre un mécanisme indicateur (6) relié à l'unité de commande et destiné à montrer continuellement à l'utilisateur l'intensité lumineuse, qu'elle soit allumée ou éteinte.

3. Dispositif de commande (1) selon la revendication 1, **caractérisé en ce que** le mécanisme de commutation comprend un interrupteur à deux états qui permet, selon son état ouvert ou fermé, d'alimenter électriquement le système d'éclairage.

4. Dispositif de commande (1) selon la revendication 1, **caractérisé en ce que** l'interface comprend au moins un capteur capacitif qui recouvre sensiblement la totalité de sa surface interne.

5. Dispositif de commande (1) selon la revendication 4, **caractérisé en ce que** l'interface comprend deux capteurs capacitifs qui recouvrent sensiblement la totalité de sa surface interne et qui sont capables de produire un signal de réglage analogique essentiellement linéaire en fonction d'un mouvement linéaire effectué par l'utilisateur sur la surface externe (3) de l'interface.

6. Dispositif de commande (1) selon la revendication 5, **caractérisé en ce que** l'unité de commande comprend un premier microcontrôleur qui lui-même comprend au moins un convertisseur analogique/numérique pour convertir un signal de réglage analogique en un signal numérique.

7. Dispositif de commande (1) selon la revendication 1, **caractérisé en ce qu'il** comprend en outre un mécanisme de communication sans fil connecté à l'unité de commande en vue de permettre la communication avec les mécanismes externes.

8. Dispositif de commande (1) selon la revendication 2 et la revendication 7, dans lequel le capteur est disposé parallèlement à l'axe de rotation du bouton à bascule (2) de sorte que l'intensité lumineuse est commandée au moyen d'un mouvement linéaire parallèle à l'axe de rotation du bouton à bascule (2), et le mécanisme indicateur (6) comprend une pluralité de DEL commandées par ladite unité de commande du mécanisme de réglage pour être allumées linéairement en fonction de l'intensité lumineuse du luminaire, celui-ci étant allumé ou éteint, et le mécanisme de communication sans fil comprend une antenne radiofréquence et un module radiofréquence.
